Europäisches Patentamt

European Patent Office

Office européen des brevets

(19)

(11) EP 0 847 193 A1

(12) ## DEMANDE DE BREVET EUROPEEN

(43) Date de publication:
10.06.1998 Bulletin 1998/24

(51) Int. Cl.⁶: $H04N\ 5/50$, $H04N\ 5/44$, $H04N\ 5/52$

(21) Numéro de dépôt: 97203717.0

(22) Date de dépôt: 27.11.1997

(84) Etats contractants désignés:
AT BE CH DE DK ES FI FR GB GR IE IT LI LU MC
NL PT SE
Etats d'extension désignés:
AL LT LV MK RO SI

(30) Priorité: 06.12.1996 FR 9615050
14.01.1997 FR 9700299

(71) Demandeur:
Philips Electronics N.V.
5621 BA Eindhoven (NL)

(72) Inventeurs:
• Chevallier, Gilles
75008 Paris (FR)
• Crand, Olivier
75008 Paris (FR)

(74) Mandataire: Caron, Jean
Société Civile S.P.I.D.
156, Boulevard Haussmann
75008 Paris (FR)

(54) **Circuit d'amplification pour un signal à fréquence intermédiaire d'un récepteur d'ondes hertziennes**

(57) Le circuit (7, 8, 9, 10) comprend, en plus du réglage de gain général (AGC), un moyen propre de réglage de gain d'un amplificateur (8), destiné à éviter la dé-synchronisation de l'oscillateur local (7) contrôlé par un comparateur de phase à boucle d'asservissement (12). Ce moyen est commandé par un détecteur des crêtes du signal amplifié, situé en sortie de l'amplificateur (8).

Applications : télévision

FIG. 1

EP 0 847 193 A1

## Description

La présente invention concerne un circuit intégré comprenant entre autres un circuit d'amplification à fréquence intermédiaire destiné à fonctionner en association avec un oscillateur local muni d'un synthétiseur de fréquence et d'un comparateur de phase à boucle d'asservissement, et avec d'autres éléments d'amplification, le tout étant muni d'un moyen général de réglage de gain.

L'invention a été conçue pour la réception de la télévision, mais elle s'applique aussi à d'autres appareils munis d'un synthétiseur de fréquence avec une boucle de réglage de fréquence et d'un moyen général de réglage automatique de gain.

Un objet de l'invention est de résoudre un problème spécifique aux circuits d'amplification pour les récepteurs d'ondes hertziennes, qui est le suivant : la synchronisation de la fréquence de l'oscillateur local a tendance à se dégrader lorsque l'amplificateur à fréquence intermédiaire sature. La fréquence d'oscillateur local est réglée par le comparateur de phase à boucle d'asservissement, dit PLL, qui compare les passages à zéro du signal à régler avec ceux d'une référence. Lorsque l'amplificateur à fréquence intermédiaire sature, il engendre des signaux additionnels parasites, notamment à cause des retours de masse véhiculant des harmoniques, et ces signaux additionnels sont comptés par le comparateur de phase PLL comme des passages à zéro du signal utile, ce qui fausse la régulation de fréquence.

Pour résoudre ce problème, au moins un étage du circuit d'amplification à fréquence intermédiaire est muni d'un moyen propre de réduction automatique de son gain lorsqu'un circuit de détection de crêtes d'amplitude du signal à fréquence intermédiaire détecte que ce dernier dépasse un seuil déterminé, moyen propre agissant indépendamment du moyen général de réglage de gain, avec une constante de temps et une détection d'amplitude propres.

L'invention est donc basée sur l'idée de réaliser, pour éviter la dé-synchronisation de la fréquence de l'oscillateur local, un contrôle automatique de gain localisé, indépendant du moyen général du récepteur (dit "AGC"), lequel continue à agir de son côté, indépendamment du moyen propre à l'amplificateur à fréquence intermédiaire.

Il est vrai que des circuits amplificateurs munis d'un système de contrôle automatique de gain autonome sont connus dans le domaine des amplificateurs opérationnels. Un tel amplificateur est décrit par exemple dans l'abrégé de brevet Japonais 63-313905. Toutefois les problèmes que ces amplificateurs cherchent à résoudre sont complètement différents de ceux rencontrés dans un récepteur d'ondes hertziennes en présence d'un comparateur PLL et d'un oscillateur. En outre, dans le cas de l'invention, on pourrait craindre que le moyen propre de réduction automatique du gain qui s'ajoute à l'AGC général perturbe le fonctionnement de ce dernier, ou entre autres crée une instabilité or il n'en est rien, grâce au fait que, si l'on compare à l'AGC général, le mode de détection du dit moyen propre est basé sur un seuil, et ce seuil correspond à un niveau relativement élevé du signal, en même temps que la constante de temps de la commande est différente.

Dans un mode de réalisation particulier, le circuit de détection de crêtes d'amplitude est muni de moyens pour présenter le signal d'erreur avec une constante de temps de l'ordre de quelques microsecondes.

Le circuit de détection des crêtes d'amplitude est avantageusement un générateur de courant qui engendre un courant servant à l'élaboration du signal d'erreur en fonction de la différence entre la valeur de crête du signal à fréquence intermédiaire et une valeur de référence.

Dans un mode de réalisation particulier, le circuit de détection des crêtes d'amplitude comprend une paire de transistors dite paire différentielle, dont la base du premier transistor de la paire différentielle reçoit un signal à fréquence intermédiaire de sortie de l'amplificateur, la base du second transistor de la paire différentielle est reliée à une tension de référence, et le collecteur de l'un des transistors de la paire différentielle est relié à une source de tension par une capacité en parallèle avec l'arrangement en série d'une résistance et de l'espace base-émetteur d'un transistor qui est de polarité opposée à celle des transistors de la paire différentielle et dont le collecteur constitue une sortie en courant qui fournit un courant servant à l'élaboration du signal d'erreur.

Le circuit d'amplification comporte avantageusement au moins un pont diviseur à l'entrée de l'amplificateur, comportant, dans le trajet de signal à fréquence intermédiaire, au moins un élément semi-conducteur qui présente une impédance variable en fonction d'un courant de repos qui le traverse, courant commandé au moyen du signal d'erreur, l'autre élément du pont diviseur étant constitué par l'impédance interne d'entrée de l'amplificateur.

Ainsi, l'impédance dynamique des éléments du pont diviseur peut être commandée facilement, et une constante de temps est créée.

De préférence, l'élément semi-conducteur est l'espace base-émetteur d'un transistor monté en émetteur suiveur.

Ainsi, une impédance élevée est offerte en entrée du montage.

Le circuit peut comprendre en outre au moins une diode, placée dans le chemin du courant servant à l'élaboration du signal d'erreur, pour créer une tension qui est appliquée à la base du premier transistor d'une paire de transistors dite paire différentielle, le collecteur du second transistor de cette paire constituant la source du dit courant de repos qui traverse un élément semi-conducteur d'impédance variable.

Avantageusement, les dits moyens propres présentent une constante de temps différente selon qu'il s'agit d'augmenter ou de diminuer le gain.

Ceci a pour effet de déclencher une activation rapide du contrôle de gain et une désactivation plus lente.

Le circuit d'amplification comprend, pour générer l'une des constantes de temps, un transistor monté en émetteur commun avec une résistance de charge de collecteur, et muni d'une capacité entre son collecteur et sa base, laquelle est commandée à partir du signal d'erreur, et, pour générer l'autre constante de temps, un transistor monté en émetteur suiveur dont l'émetteur est relié à la masse par une résistance, dont la base est commandée à partir du signal d'erreur, dont le trajet principal de courant est traversé par le courant d'erreur, et dont la base est reliée à la dite résistance de charge par une capacité, ainsi qu'un transistor dont l'émetteur est relié à la base du transistor monté en émetteur suiveur, la base est reliée au collecteur de ce même transistor, et le collecteur est relié à une tension d'alimentation.

Ainsi, le circuit utilise des capacités de valeur réduite, de façon qu'elles soient intégrables.

Ces aspects de l'invention ainsi que d'autres aspects plus détaillés apparaîtront plus clairement grâce à la description suivante d'un mode de réalisation constituant un exemple non limitatif.

La figure 1 représente schématiquement un récepteur d'ondes hertziennes.

La figure 2 est un schéma d'une partie d'un circuit d'amplification à fréquence intermédiaire.

La figure 3 représente en A un schéma d'un circuit de détection des crêtes d'amplitude et en B une forme d'onde illustrant le fonctionnement.

La figure 4 représente en A un schéma d'une source de courant, avec trois diodes dans le chemin du courant pour créer une tension logarithmique, et en B une courbe illustrant le fonctionnement.

La figure 5 est un schéma d'une partie d'une variante d'un circuit d'amplification à fréquence intermédiaire, avec un circuit à deux constantes de temps pour la commande de gain.

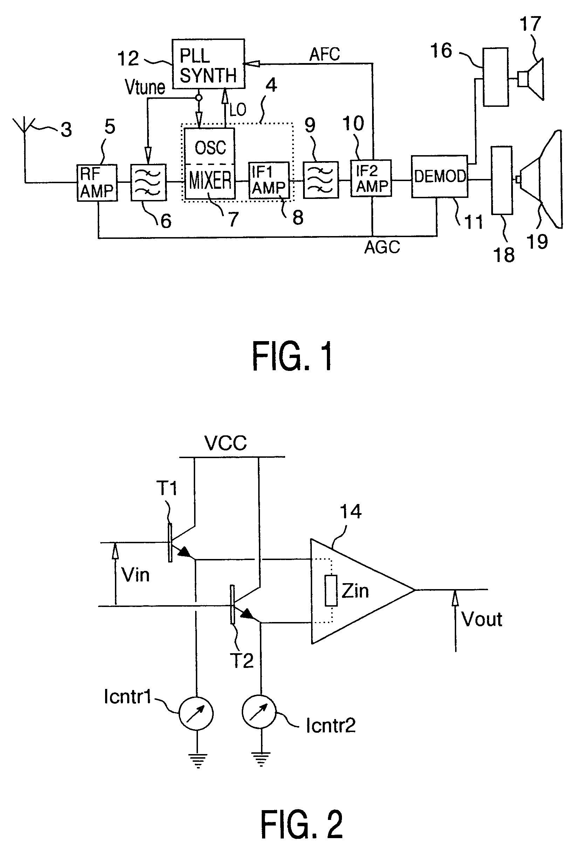

Le récepteur de télévision représenté par la figure 1 comprend, à partir d'une antenne 3, un amplificateur radio-fréquences 5, un filtre passe-bande à fréquence réglable 6, un changeur de fréquence 7 avec un oscillateur local, un premier amplificateur à fréquence intermédiaire 8, un filtre passe-bande 9, un deuxième amplificateur à fréquence intermédiaire 10, un démodulateur 11, un circuit de traitement vidéo 18, un tube cathodique 19, un circuit de traitement audio 16, un hautparleur 17.

L'oscillateur local est piloté par un synthétiseur de fréquence 12 dit "PLL", qui comporte une boucle de contrôle de phase et asservit, au moyen d'une tension de commande Vtune, la fréquence de l'oscillateur local, de façon connue. Le démodulateur 11 fournit en outre une tension AGC représentant l'amplitude du signal amplifié qu'il reçoit de l'amplificateur 10, permettant le réglage automatique du gain des amplificateurs 10 et 5. Plusieurs éléments de cet ensemble peuvent être réalisés dans un même circuit intégré, par exemple les éléments compris dans un cadre 4.

Le circuit représenté sur la figure 2, qui est une partie de l'amplificateur 8 de la figure 1, comporte un amplificateur 14 proprement dit, connu en soi et qui ne demande pas plus de description. Il est symétrique avec deux entrées équilibrées recevant un signal Vin, et une sortie fournissant un signal Vout. Son impédance d'entrée est égale à Zin.

L'espace base-émetteur d'un transistor T1 ou T2, monté en émetteur suiveur et chargé par une source de courant respectivement Icntr1 ou Icntr2, est placé dans le trajet de signal de chacune des entrées. Un pont diviseur est constitué d'une part par l'impédance dynamique de chacun de ces espaces base-émetteur, et d'autre part par l'impédance interne d'entrée Zin de l'amplificateur. Selon la valeur du courant moyen débité par la source Icntr1 ou Icntr2, l'impédance dynamique de l'espace base-émetteur du transistor varie : si le courant de la source Icntr1 ou Icntr2 augmente, l'impédance dynamique diminue, et le gain de l'amplificateur augmente.

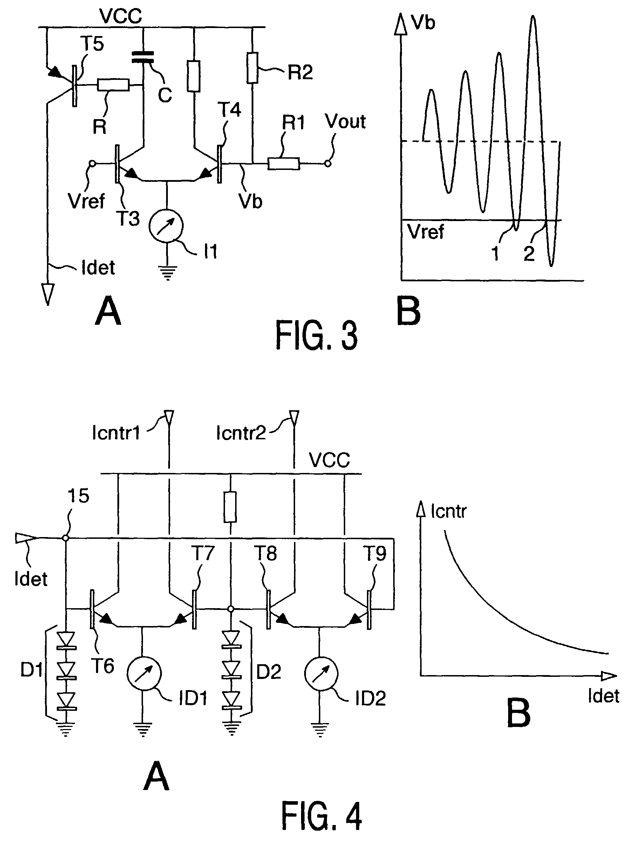

Une partie d'un circuit fournissant un courant d'erreur est représentée par la figure 3A. Ce circuit possède une borne qui reçoit un signal Vout, issu de l'amplificateur. Le circuit comprend une paire, dite paire différentielle, faite de deux transistors T3 et T4 de type NPN, dont les émetteurs sont alimentés ensemble par une source de courant I1. La base du premier transistor T4 reçoit un signal représentant le signal de sortie de l'amplificateur, à partir du point commun des résistances R1 et R2. La base du second transistor T3 est reliée à une tension de référence Vref, et son collecteur est relié à une source de tension VCC via une capacité C, en parallèle avec l'arrangement série d'une résistance R et de l'espace base-émetteur d'un transistor PNP T5, de polarité opposée à celle (NPN) des transistors de la paire différentielle. Le collecteur du transistor T5 fournit un courant "Idet" servant à l'élaboration du signal d'erreur. La capacité C procure une constante de temps.

La figure 3B illustre une forme d'onde appliquée à la base du transistor T4, dont l'amplitude est en train d'augmenter. Au début, le signal a une valeur qui est toujours au dessus de celle de la tension de référence Vref, le transistor T4 conduit, le transistor T3 est bloqué. Au point 1, la crête inférieure du signal descend sous la tension Vref, ce qui bloque le transistor T4, et donc ouvre le transistor T3, induisant un courant Idet. Au point 2, cela se produit à nouveau, par exemple parce que la correction apportée par le courant Idet est encore insuffisante. Grâce à la constante de temps procurée par l'ensemble RC, le courant Idet ne suit pas exactement les impulsions 1 et 2, mais évolue en intégrant les impulsions 1 ou 2. La constante de temps est choisie d'environ 3 à 5 microsecondes, dans le cas d'une fréquence intermédiaire à une quarantaine de mégahertz.

Le circuit de la figure 4A sert à engendrer les courants Icntr1 et Icntr2 pour la commande d'impédance dynamique des transistors de la figure 2, à partir du courant Idet du détecteur des crêtes d'amplitude de la figure 3A ; ce courant est amené à une borne d'entrée 15 reliée à la masse via trois diodes D1 en série, de façon à créer une tension logarithmique à partir du courant Idet. L'entrée 15 est reliée à la base d'un premier transistor T6 d'une paire de transistors dite paire différentielle, dont les émetteurs sont alimentés ensemble par une source de courant ID1. La base du second transistor T7 de la paire est reliée à la masse par trois diodes D2 alimentées en courant à partir de VCC va une résistance, afin d'équilibrer la polarisation, au repos, pour les deux transistors T6 et T7. Le collecteur du second transistor T7 de cette paire fournit le courant Icntr1. La valeur du courant ID1 détermine le courant de repos Icntr1 du transistor T1. Deux autres transistors T8 et T9, reliés aux mêmes sources de polarisation D1 et D2, fournissent de façon semblable le courant Icntr2. La courbe de la figure 4B montre l'effet produit par les diodes : le courant produit Icntr1 (ou Icntr2) diminue lorsque Idet augmente, d'abord rapidement, puis de plus en plus lentement ; l'attaque de la paire différentielle est logarithmique.

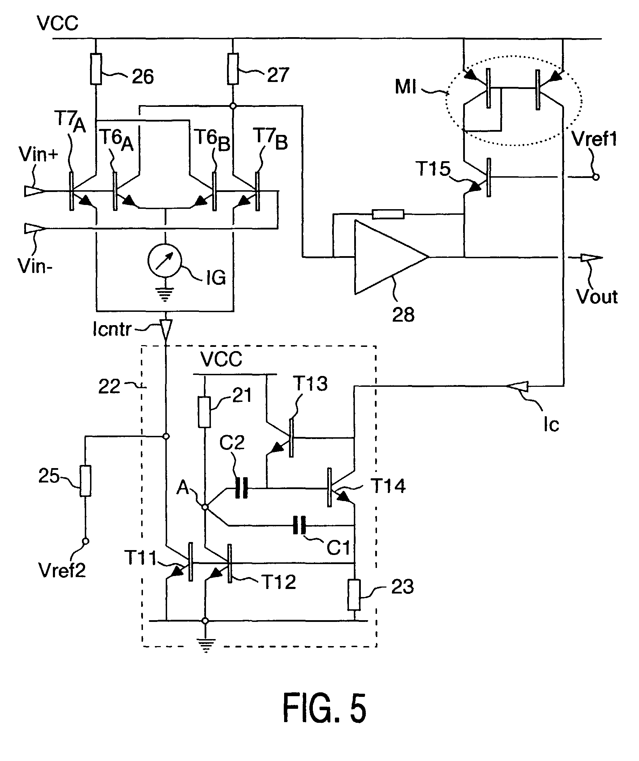

Le circuit représenté par la figure 5 constitue une variante de réalisation de l'amplificateur 8 de la figure 1. Il comporte un amplificateur à fréquence intermédiaire 28 connu en soi, dont la sortie constitue la sortie Vout du circuit. Pour permettre le réglage du gain du montage, un étage d'entrée à gain variable, fait des transistors $T6_A$ à $T7_B$, est placé en amont de l'amplificateur 28. Cet étage comprend deux paires différentielles $T6_A/T6_B$ et $T7_A/T7_B$. Les émetteurs de la paire $T6_A/T6_B$ sont alimentés en courant par un générateur fixe de courant IG, et ceux de la paire $T7_A/T7_B$ sont reliés à un module de commande 22 qui tire un courant Icntr. Le signal à amplifier est symétrique, c'est-à-dire constitué par deux composantes Vin+ et Vin-. Le signal Vin+ est amené sur la base du transistor $T6_A$ et sur celle du transistor $T7_A$, et le signal Vin- est amené sur la base du transistor $T6_B$ et sur celle du transistor $T7_B$. Les collecteurs des transistors $T6_B$ et $T7_A$ sont reliés ensemble à une alimentation VCC via une résistance 26, et ceux des transistors $T6_A$ et $T7_B$ sont reliés ensemble à l'entrée de l'amplificateur 28, et à l'alimentation VCC via une résistance 27. Il est clair que lorsque le courant Icntr appelé par le module 22 varie, le gain du montage $T7_A$-$T7_B$ est modifié, ainsi que la grandeur du signal à l'entrée de l'amplificateur 28. La sortie Vout est reliée à l'émetteur d'un transistor T15 dont la base est connectée à une tension de référence Vref1. Lorsque les crêtes vers le bas du signal Vout, moins la tension base-émetteur du transistor T15, descendent sous la valeur Vref1, le transistor T15 devient conducteur, et son courant de collecteur, "retourné" par un miroir de courant MI, fournit un courant Ic au module 22. Ce dernier comporte un transistor T11 dont le collecteur, relié à une source de tension de référence Vref2 via une résistance 25, fournit le courant de commande Icntr, et dont la base est reliée à celle d'un transistor T12. Les émetteurs des transistors T11 et T12 sont reliés à la masse, et le collecteur du transistor T12, appelé "noeud A", est relié à l'alimentation VCC via une résistance de charge 21. Un transistor T13 a son collecteur relié à l'alimentation VCC et son émetteur relié d'une part à la base d'un transistor T14 et d'autre part au noeud A via une capacité C2. Le collecteur du transistor T14 et la base du transistor T13 sont reliés ensemble à la connexion d'amenée du courant Ic, et l'émetteur du transistor T14 est relié à la masse via une résistance 23, et au noeud A via une capacité C1. Le montage profite de l'effet "Miller" connu : le courant Ic, ayant traversé T14, se répartit pratiquement entre la résistance 23 et la capacité C1, en supposant négligeable le courant de base de T12, et lorsque la tension monte sur la base de T12, alors qu'elle baisse en A, tout se passe comme si la valeur de la capacité C1 était plus grande qu'elle n'est. Il est donc possible d'utiliser une capacité C1 de faible valeur, donc intégrable. La capacité C2 est chargée très vite à travers le trajet principal de courant de T13, et n'intervient pratiquement pas dans l'établissement du courant de T12. Lorsqu'un courant Ic vient de s'établir, un courant $\beta \times Ic / 2$, où $\beta$ est le gain en courant, s'établit donc progressivement dans T11 et T12, avec une constante de temps $\tau = R \times C1$. Lorsque Ic disparaît, le courant collecteur de T11 et T12 disparaît, mais dans ce cas avec une constante de temps $\tau = R \times (C1 + C2)$.

## Revendications

1. Circuit intégré comprenant entre autres un circuit d'amplification à fréquence intermédiaire destiné à fonctionner en association avec un oscillateur local muni d'un synthétiseur de fréquence et d'un comparateur de phase à boucle d'asservissement, et avec d'autres éléments d'amplification, le tout étant muni d'un moyen général de réglage de gain, **caractérisé en ce que**, pour éviter une dé-synchronisation de la fréquence de l'oscillateur local, au moins un étage du circuit d'amplification à fréquence intermédiaire est muni d'un moyen propre de réduction automatique de son gain lorsqu'un circuit de détection de crêtes d'amplitude du signal à fréquence intermédiaire détecte que ce dernier dépasse un seuil déterminé, moyen propre agissant indépendamment du moyen général de réglage de gain, avec une constante de temps et une détection d'amplitude propres.

2. Circuit intégré selon la revendication 1, **caractérisé en ce que** le circuit de détection de crêtes d'amplitude est muni de moyens pour présenter le signal d'erreur avec une constante de temps de l'ordre de quelques microsecondes.

3. Circuit intégré selon la revendication 1, **caractérisé en ce que** le circuit de détection des crêtes d'amplitude est un générateur de courant qui engendre un courant servant à l'élaboration du signal d'erreur en fonction de la différence entre la valeur de crête du signal à fréquence intermédiaire et une valeur de référence.

4. Circuit intégré selon la revendication 3, **caractérisé en ce que** le circuit de détection des crêtes d'amplitude comprend une paire de transistors dite paire différentielle, dont la base du premier transistor de la paire différentielle reçoit un signal à fréquence intermédiaire de sortie de l'amplificateur, la base du second transistor de la paire différentielle est reliée à une tension de référence, et le collecteur de l'un des transistors de la paire différentielle est relié à une source de tension par une capacité en parallèle avec l'arrangement en série d'une résistance et de l'espace base-émetteur d'un transistor qui est de polarité opposée à celle des transistors de la paire différentielle et dont le collecteur constitue une sortie en courant qui fournit un courant servant à l'élaboration du signal d'erreur.

5. Circuit intégré selon la revendication 1, **caractérisé en ce qu'**il comporte au moins un pont diviseur à l'entrée de l'amplificateur, comportant, dans le trajet de signal à fréquence intermédiaire, au moins un élément semi-conducteur qui présente une impédance variable en fonction d'un courant de repos qui le traverse, courant commandé au moyen du signal d'erreur, l'autre élément du pont diviseur étant constitué par l'impédance interne d'entrée de l'amplificateur.

6. Circuit intégré selon la revendication 5, **caractérisé en ce que** l'élément semi-conducteur est l'espace base-émetteur d'un transistor monté en émetteur suiveur.

7. Circuit intégré selon la revendication 5, **caractérisé en ce qu'**il comprend au moins une diode, placée dans le chemin du courant servant à l'élaboration du signal d'erreur, pour créer une tension qui est appliquée à la base du premier transistor d'une paire de transistors dite paire différentielle, le collecteur du second transistor de cette paire constituant la source du dit courant de repos qui traverse un élément semi-conducteur d'impédance variable.

8. Circuit intégré selon la revendication 1, caractérisé en ce que les dits moyens propres présentent une constante de temps différente selon qu'il s'agit d'augmenter ou de diminuer le gain.

9. Circuit intégré selon la revendication 8, caractérisé en ce que, pour générer l'une des constantes de temps, il comprend un transistor (T12) monté en émetteur commun avec une résistance de charge de collecteur, et muni d'une capacité (C1) entre son collecteur et sa base, laquelle est commandée à partir du signal d'erreur.

10. Circuit intégré selon la revendication 9, caractérisé en ce qu'il comprend, pour générer l'autre constante de temps, un transistor (T14) monté en émetteur suiveur dont l'émetteur est relié à la masse par une résistance, dont la base est commandée à partir du signal d'erreur, dont le trajet principal de courant est traversé par le courant d'erreur, et dont la base est reliée à la dite résistance de charge par une capacité (C2), ainsi qu'un transistor (T13), dont l'émetteur est relié à la base du transistor monté en émetteur suiveur, la base est reliée au collecteur de ce même transistor, et le collecteur est relié à une tension d'alimentation.

FIG. 1

FIG. 2

6

FIG. 3

FIG. 4

FIG. 5

Office européen
des brevets

**RAPPORT DE RECHERCHE EUROPEENNE**

Numéro de la demande

EP 97 20 3717

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | EP 0 439 435 A (SGS-THOMSON MICROELECTRONICS S.R.L.)<br>* colonne 4, ligne 57 - colonne 5, ligne 19 *<br>* colonne 10, ligne 35 - ligne 49 *<br>--- | 1,8-10 | H04N5/50<br>H04N5/44<br>H04N5/52 |
| X | US 4 884 141 A (HYAKUTAKE J.)<br>* colonne 2, ligne 56 - colonne 3, ligne 22 *<br>--- | 1,8-10 | |
| X | US 4 827 511 A (MASUKO A.)<br>* colonne 4, ligne 35 - colonne 6, ligne 30 *<br>* colonne 9, ligne 38 - ligne 48 *<br>--- | 1,8-10 | |
| X | US 4 292 598 A (YASUMURA H.)<br>* colonne 3, ligne 10 - ligne 17 *<br>* colonne 4, ligne 26 - ligne 47 *<br>--- | 1,8-10 | |
| X | US 5 365 279 A (HARFORD J.)<br>* colonne 17, ligne 53 - colonne 21, ligne 16 *<br>--- | 1,8-10 | **DOMAINES TECHNIQUES RECHERCHES (Int.Cl.6)** |
| A | US 5 337 091 A (HARFORD J. ET AL)<br>* colonne 20, ligne 39 - colonne 22, ligne 29 *<br>--- | 1 | H04N<br>H04B<br>H03G<br>H04H |
| A | US 4 360 929 A (ISOBE MITSUO)<br>* colonne 1, ligne 65 - colonne 2, ligne 40 *<br>--- | 1 | |
| A | US 3 976 943 A (CIPHER J. ET AL)<br>* le document en entier *<br>--- | 1 | |
| A | US 5 465 408 A (SUGAYAMA S. ET AL)<br>* colonne 1, ligne 14 - colonne 1, ligne 64 *<br>--- | 1 | |

-/--

Le présent rapport a été établi pour toutes les revendications

| Lieu de la recherche | Date d'achèvement de la recherche | Examinateur |
|---|---|---|
| LA HAYE | 5 février 1998 | Verschelden, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**Office européen des brevets**

## RAPPORT DE RECHERCHE EUROPEENNE

Numéro de la demande

EP 97 20 3717

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | LONG M. ET AL: "An Integrated Video IF Amplifier and PLL Detection System" IEEE TRANSACTIONS ON CONSUMER ELECTRONICS., vol. 28, no. 3, 30 août 1982, NEW YORK US, pages 168-183, XP002035876 * le document en entier * | 1 | |

**DOMAINES TECHNIQUES RECHERCHES (Int.Cl.6)**

Le présent rapport a été établi pour toutes les revendications

| Lieu de la recherche | Date d'achèvement de la recherche | Examinateur |
|---|---|---|
| LA HAYE | 5 février 1998 | Verschelden, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)